# EUROPEAN PATENT APPLICATION

(11) **EP 1 328 068 A1**
(43) Date of publication of application: **16.07.2003**
(21) Application number: 02000538.5
(22) Date of filing: 09.01.2002
(51) Int. Cl.: H04B 1/38, H04M 1/02

(54) **A grounding device for a portable radio terminal**

(30) Priority: 09.01.2002 KR 2001001073
(71) Applicant: SAMSUNG ELECTRONICS CO., LTD., Suwon-City, Kyungki-do (KR)
(72) Inventor: Jeon, Sang-Ryel, Seoul (KR)
(74) Representative: Grünecker, Kinkeldey, Stockmair & Schwanhäusser Anwaltssozietät

(57) **Abstract**

There is provided a grounding device to prevent an ESD (Electro-Static Discharge) in a portable radio terminal having a main body with an upper casing frame, a lower casing frame, an RF board mounted to the main body, and an FPC integrated with an LCD module by an electrical connection mounted on the RF board. At least one metal grounding portion is extended outwardly from the FPC and is electrically connected to the inner side surface of the main body on which a conductive material is coated to increase a grounding area when the FPC is mounted to the main body. Therefore, the ESD problem is solved by the utilization of at least one metal grounding portion.

## Description

### BACKGROUND OF THE INVENTION

### 1. Field of the Invention

The present invention relates generally to a portable radio terminal, and in particular, to a grounding device, which prevents a high voltage caused by external static electricity from damaging a portable radio terminal.

### 2. Description of the Related Art

Portable radio terminals have become smaller and more lightweight to satisfy customers' demands, whereas their functions have become more diverse and more complicated. Aside from a voice call, a portable radio terminal plays music, supports TV broadcasting, Internet browsing, and even functions as a digital camera. To implement these functions, a display device with a wide LCD (Liquid Crystal Display) module has been developed to display received data or entered data. Accordingly, the area needed for the placement of the LCD in the portable radio terminal has increased.

Use of an enlarged LCD may induce external static electricity at high voltage or ESD (Electro-Static Discharge) inside a portable radio terminal. In order to reduce the static electricity in a portable radio terminal, the static electricity has to be grounded by a predetermined grounding device. The LCD module is usually connected electrically to a FPC (flexible printed circuit) on which metal domes of a keypad assembly are attached and connected to an RF (Radio Frequency) board of a main body by a predetermined connector. The induced high-voltage static electricity is introduced into the RF board via the connector of the FPC and then grounded.

However, the FPC that electrically connects the LCD module to the RF board does not entirely ground high-voltage static electricity that is at a level of several kilovolts, when the static electricity is introduced via the LCD module or an outwardly protruding button to a portable radio terminal. Thus, the resulting electrical impact of the high-voltage static electricity causes the radio terminal to malfunction.

### SUMMARY OF THE INVENTION

It is, therefore, an object of the present invention to provide an extended grounding device for preventing ESD (Electro-Static Discharge), which reliably grounds high-voltage static electricity introduced through an LCD module or an outwardly protruding button to a portable radio terminal.

It is another object of the present invention to provide a grounding device, which prevents the malfunction of a portable radio terminal caused by an external electrical impact of the high-voltage static electricity to a portable radio terminal.

The foregoing and other objects are achieved by a grounding device for a portable radio terminal having a main body with an upper casing frame, a lower casing frame, an RF board mounted to the main body, and an FPC integrated with an LCD module by an electrical connection on the RF board. The grounding device includes a predetermined ground for grounding static electricity introduced into the FPC and the RF board from a source outside of the terminal to a conductive material that is coated on the inner side surface of the main body to increase a grounding area.

### BRIEF DESCRIPTION OF THE DRAWINGS

The above and other objects, features and advantages of the present invention will become more apparent from the following detailed description when taken in conjunction with the accompanying drawings in which:
FIG. 1 is a perspective view of a typical portable radio terminal;
FIG. 2 is a perspective view of an FPC having a metal grounding portion, according to a preferred embodiment of the present invention; and
FIG. 3 is a sectional view of a portable radio terminal, illustrating connection between the metal grounding portion of the FPC connected to a main body, according to the preferred embodiment of the present invention.

### DETAILED DESCRIPTION OF THE PREFERRED EMBODIMENT

A preferred embodiment of the present invention will be described hereinbelow with reference to the accompanying drawings. In the following description, well-known functions or constructions are not described in detail since they would obscure the invention in unnecessary detail.

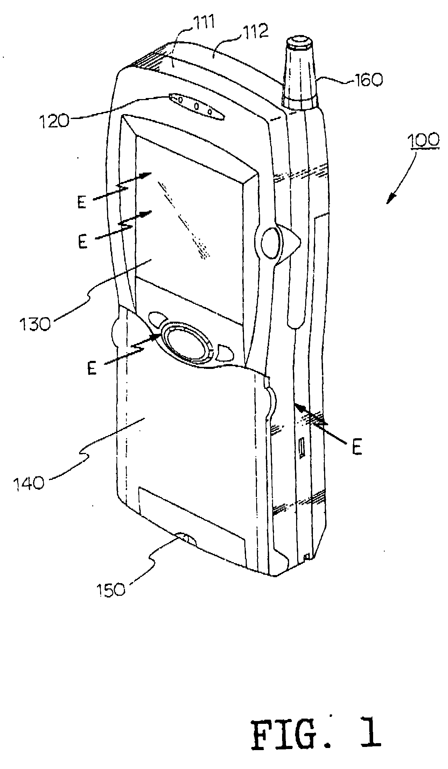

FIG. 1 is a perspective view of a typical portable radio terminal. Referring to FIG. 1, the portable radio terminal has a main body 100 comprised of an upper casing frame 111, a lower casing frame 112, a speaker 120, an LCD module 130, a flip cover 140, a microphone 150 and an antenna device 160. Speaker 120 is utilized for outputting received voice information or audio data. LCD module 130 is disposed under the speaker 120 for displaying input data. Flip cover 140 is rotatable with respect to the main body 100 for protecting a plurality of underlying key buttons (not shown) and collecting voice information or audio data. Microphone 150 is disposed under the flip cover 140, for transmitting voice to the other party. Antenna device 160 is installed on an uppermost end of the main body 100.

Arrows denoted by E indicates a position where external static electricity and high voltage can be introduced into the terminal.

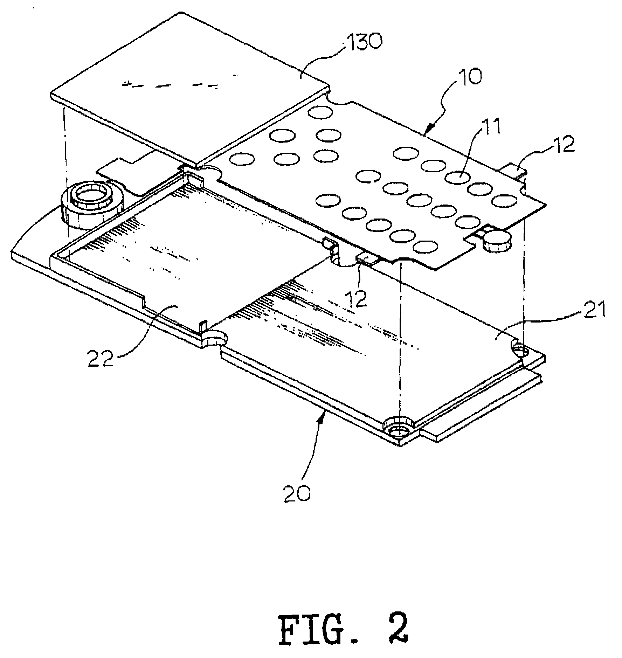

FIG. 2 is a perspective view of an FPC 10 having a metal grounding portion and an RF board 20, according to a preferred embodiment of the present invention. The FPC 10 is mounted on an RF board 20 that is a main board of the main body 100.

The FPC 10 is comprised of: a plurality of metal domes 11, a ground terminal formed as at least one metal grounding portion 12 and LCD module 130. The RF board 20 includes a shield cover 21, and a mounting portion 22.

In order to block electromagnetic waves generated from a plurality of electronic elements, of the portable radio terminal from damaging the portable radio terminal, shield cover 21 covers a portion of the RF board 20. An LCD mounting portion 22 is formed on the shield cover 21 to mount the LCD module 130 thereon.

A plurality of metal domes 11 are provided as a connection means to connect the key buttons on a portion of the FPC 10 with the RF board 20. The LCD module 130 is integrally installed on the FPC 10 by an electrical connection. The LCD module 130 is connected to the mounting portion 22 of the RF board 20 by a predetermined connector. At least one metal grounding portion 12 is outwardly extended from the FPC 10. The metal grounding portion 12 has good conductivity and a predetermined elasticity, which reliably connects it to the inner circumferential surface of the main body 100. Metal grounding portions 12 can be extended from both sides of the FPC 10 in such a way that the distance between the metal grounding portions 12 is longer than the width of the main body 100. Those of ordinary skill in the art recognize that other types of portable radio terminals such as bar-type and flip-type terminals can be utilized by this invention.

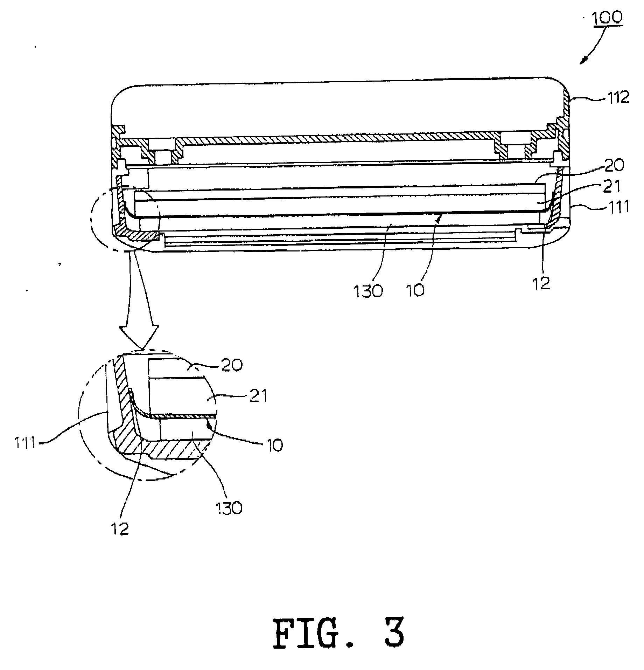

FIG. 3 is a sectional view of the portable radio terminal having the metal grounding portion 12 of the FPC 10 connected to the main body 100, according to the preferred embodiment of the present invention. Here, the FPC 10 is fixed on the shield cover 21 of the RF board 20 by a fixing means such as an adhesive. Then, the RF board 20 with the FPC 10 is mounted on the main body 100.

When the RF board 20 is mounted to the upper casing frame 111, the metal grounding portion 12 is bent with a predetermined elasticity against a corner of the frame 111. After the RF board 20 is entirely installed in the upper casing frame 111, the metal grounding portion 12 is, with predetermined elasticity, electrically connected to the inner side surface of the frame 111 on which a conductive material is coated. The coated conductive material is used to be stainless, or titanium.

Therefore, external high-voltage static electricity or ESD introduced into the terminal from, for example, the LCD module 130 is grounded into the inner side surface of the main body's 100 upper casing frame 111, coated with the conductive material through the FPC 10, and the metal grounding portion 12. That is, a plurality of grounding portions 12 grounds a high voltage introduced into the terminal to the relatively large inner surface of the frame.

In accordance with the present invention as described above, when a high voltage is externally applied to a terminal, the grounding device directly grounds the high voltage to the inner side surface of the casing frame coated with a conductive material through the FPC. Therefore, the high voltage that usually causes an RF board to malfunction will be prevented from occurring by utilizing the present invention.

While the invention has been shown and described with reference to a certain preferred embodiment thereof, it will be understood by those skilled in the art that various changes in form and details may be made therein without departing from the spirit and scope of the invention as defined by the appended claims.

## Claims

1. A grounding device for a portable radio terminal having a main body (100) with an upper casing frame (111), a lower casing frame (112), an RF (Radio Frequency) board mounted to the main body, and an FPC (Flexible Printed Circuit) integrated with an LCD (Liquid Crystal Display) module (130) by an electrical connection mounted on the RF board, comprising:
at least one ground terminal (12) for grounding static electricity introduced into the FPC and the RF board from outside of the portable radio terminal to a conductive material that is coated on an inner side surface of at least one of the upper and lower casing frames of the main body, to increase a grounding area.

2. The grounding device of claim 1, wherein the ground terminal (12) is at least one metal grounding portion extended outwardly from the FPC and electrically connected to the inner side surface of the at least one casing frame (111) of the main body having the coating of conductive material when the FPC is mounted to the main body.

3. The grounding device of claim 1, wherein the ground terminal (12) is at least one metal grounding portion having a predetermined elasticity which bends when the at least one metal grounding portion contacts the inner side surface of the at least one casing frame (111) of the main body.

4. The grounding device of claim 2, wherein the at least one metal grounding portion is formed at both sides of the FPC.
